# EUROPEAN PATENT APPLICATION

(11) **EP 4 592 533 A1**
(43) Date of publication of application: **30.07.2025**
(21) Application number: 23883037.6
(22) Date of filing: 23.10.2023
(51) Int. Cl.: F04D 17/10, F04D 29/58, F04D 29/28, F04D 29/42, F04D 25/06, H02K 5/20, H02K 9/06, H02K 9/16, H05K 7/20

(54) **TURBO COMPRESSOR CAPABLE OF COOLING POWER CONVERTER OF MOTOR**

(30) Priority: 25.10.2022 KR 20220137924
(71) Applicant: TNE Korea Co., Ltd., Cheongju-si, Chungcheongbuk-do 28220 (KR)
(72) Inventor: KIM, Kyeong Su, Daejeon 34067 (KR)
(74) Representative: BCKIP Part mbB
(86) International application number: PCT/KR2023/016484
(87) International publication number: WO 2024/090931

(57) **Abstract**

Provided is a turbo compressor capable of compressing a gas and supplying the compressed gas to outside, the turbo compressor including a motor including a rotating shaft with an end coupled to an impeller, to rotate the impeller; a housing including a motor accommodation space for accommodating the motor; a cooling gas path provided to allow a cooling gas accommodated inside to flow; a power converter provided as a device for controlling the motor, and including heat sources inside; and a heat sink provided as a thermally conductive member for cooling the heat sources of the power converter, and having an end in contact with the heat sources and the other end exposed to the motor accommodation space, wherein a compressed gas inlet is disposed at a front end of the housing, wherein the impeller is disposed at a rear end of the housing, wherein the motor is disposed between the compressed gas inlet and the impeller, wherein the cooling gas path includes a fourth cooling gas path starting from the compressed gas inlet, passing through the other end of the heat sink, and reaching the impeller, and wherein the gas sucked in from the compressed gas inlet by suction force of the impeller passes through the fourth cooling gas path to cool the heat sources of the power converter. According to the present invention, the heat sources of the power converter may be rapidly cooled using a relatively low-temperature cooling gas sucked in from the compressed gas inlet.

## Description

### TECHNICAL FIELD

The present invention relates to a turbo compressor, and more particularly, to a turbo compressor capable of rapidly cooling heat sources of a power converter using a relatively low-temperature cooling gas sucked in from a compressed gas inlet.

### BACKGROUND ART

A turbo compressor or turbo blower is a centrifugal pump that sucks in and compresses external air or gas and then discharges the compressed air or gas to the outside by rotating an impeller at high speed, and is commonly used for powder transfer or aeration in sewage treatment plants and also used in industrial processes or mounted on vehicles these days.

In the turbo compressor, high heat is inevitably produced by friction at a motor and bearings due to the high-speed rotation of the impeller, and also at a power converter for supplying power to the motor. Thus, major heat sources such as the motor, bearings, and power converter need to be cooled.

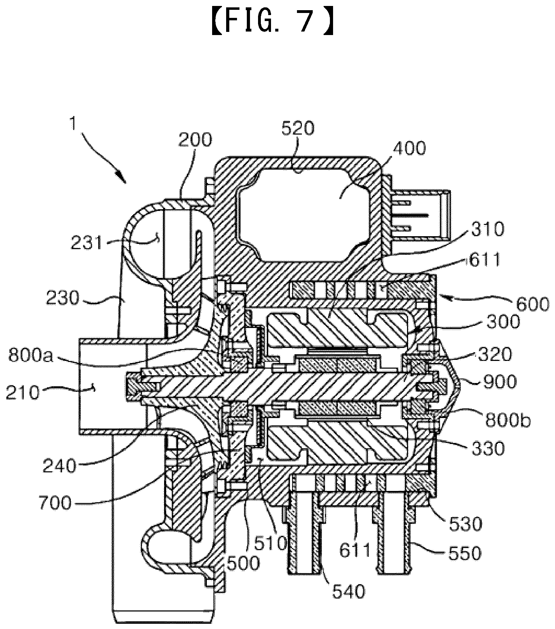

An example of a general turbo compressor is shown in FIG. 7. This turbo compressor 1 is an automotive air blower, and has a structure including a volute housing 200, an impeller 240 mounted in the volute housing to compress air, a motor 300 for driving the impeller, and a motor housing 500 coupled to a side of the volute housing to mount the motor therein, and including an inverter control module 400 at a side, wherein a coolant cover 600 through which a coolant circulates is coupled to a side of the motor housing 500.

However, the general turbo compressor 1 additionally requires a coolant supply system because the inverter control module 400 and the motor 300 are cooled using a coolant, and also requires a sealing design to prevent leakage in a module accommodator 520 accommodating the inverter control module 400, and a motor accommodator 510 accommodating the motor.

In addition, the general the turbo compressor 1 has a complex production process and a high total production cost because a complex-shaped coolant path 611 needs to be formed in the coolant cover 600.

### DETAILED DESCRIPTION OF THE INVENTION

### TECHNICAL PROBLEM

The present invention provides a turbo compressor with an improved structure to easily cool heat sources of a power converter using a relatively low-temperature cooling gas sucked in from a compressed gas inlet.

### TECHNICAL SOLUTION

According to an aspect of the present invention, there is provided a turbo compressor capable of compressing a gas and supplying the compressed gas to outside, the turbo compressor including a compressed gas inlet for sucking in the gas; an impeller for compressing the gas introduced through the compressed gas inlet; a compressed gas outlet for discharging the gas compressed by the impeller, to outside; a compression unit including the compressed gas inlet, the impeller, the compressed gas outlet, and a compressed gas path connected from the compressed gas inlet to the compressed gas outlet; a motor including a rotating shaft with an end coupled to the impeller, to rotate the impeller; a housing including a motor accommodation space for accommodating the motor; a cooling gas path provided to allow a cooling gas accommodated inside to flow; a power converter provided as a device for controlling the motor, and including heat sources inside; and a heat sink provided as a thermally conductive member for cooling the heat sources of the power converter, and having an end in contact with the heat sources and the other end exposed to the motor accommodation space, wherein the compressed gas inlet is disposed at a front end of the housing, wherein the impeller is disposed at a rear end of the housing, wherein the motor is disposed between the compressed gas inlet and the impeller, wherein the cooling gas path includes a fourth cooling gas path starting from the compressed gas inlet, passing through the other end of the heat sink, and reaching the impeller, and wherein the gas sucked in from the compressed gas inlet by suction force of the impeller passes through the fourth cooling gas path to cool the heat sources of the power converter.

The power converter may include a case capable of accommodating the heat sources in an internal space, the cooling gas path may include a fifth cooling gas path starting from the compressed gas inlet, passing through the internal space of the case, and reaching the impeller, and the gas sucked in from the compressed gas inlet by suction force of the impeller may pass through the fifth cooling gas path to cool the heat sources of the power converter.

At least one first through-hole for allowing the gas sucked in from the compressed gas inlet to flow into the motor accommodation space may be formed at the front end of the housing, and at least one second through-hole for allowing the gas accommodated in the motor accommodation space to flow toward the impeller may be formed at the rear end of the housing.

At least one of the first and second through-holes may include a plurality of through-holes arranged at predetermined intervals along a circumferential direction of the rotating shaft.

The fourth cooling gas path may start from the compressed gas inlet, pass sequentially through the first through-hole, the other end of the heat sink, and the second through-hole, and reach the impeller.

The fifth cooling gas path may start from the compressed gas inlet, pass sequentially through the first through-hole, the internal space of the case, and the second through-hole, and reach the impeller.

A plurality of cooling fins may be provided at the other end of the heat sink.

The cooling fins may protrude toward the rotating shaft, extend along a longitudinal direction of the rotating shaft, and be spaced apart from each other along a circumferential direction of the rotating shaft.

At least some of distal ends of the cooling fins may be in contact with or disposed closely within a predetermined distance from an outer surface of a stator of the motor.

The power converter may include a case capable of accommodating internal heat sources, and the case may include a metal and is coupled to an end of the heat sink to exchange heat with the heat sink.

### ADVANTAGEOUS EFFECTS

According to the present invention, a turbo compressor includes a compressed gas inlet for sucking in a gas; an impeller for compressing the gas introduced through the compressed gas inlet; a compressed gas outlet for discharging the gas compressed by the impeller, to outside; a compression unit including the compressed gas inlet, the impeller, the compressed gas outlet, and a compressed gas path connected from the compressed gas inlet to the compressed gas outlet; a motor including a rotating shaft with an end coupled to the impeller, to rotate the impeller; a housing including a motor accommodation space for accommodating the motor; a cooling gas path provided to allow a cooling gas accommodated inside to flow; a power converter provided as a device for controlling the motor, and including heat sources inside; and a heat sink provided as a thermally conductive member for cooling the heat sources of the power converter, and having an end in contact with the heat sources and the other end exposed to the motor accommodation space, wherein the compressed gas inlet is disposed at a front end of the housing, wherein the impeller is disposed at a rear end of the housing, wherein the motor is disposed between the compressed gas inlet and the impeller, wherein the cooling gas path includes a fourth cooling gas path starting from the compressed gas inlet, passing through the other end of the heat sink, and reaching the impeller, and wherein the gas sucked in from the compressed gas inlet by suction force of the impeller passes through the fourth cooling gas path to cool the heat sources of the power converter. Thus, the heat sources of the power converter may be rapidly cooled using a relatively low-temperature cooling gas sucked in from the compressed gas inlet.

### DESCRIPTION OF THE DRAWINGS

FIG. 1 is a cross-sectional view of a turbo compressor according to an embodiment of the present invention.
FIG. 2 is a partially enlarged view of the turbo compressor illustrated in FIG. 1.
FIG. 3 is a partially enlarged view of the front end of the turbo compressor illustrated in FIG. 2.

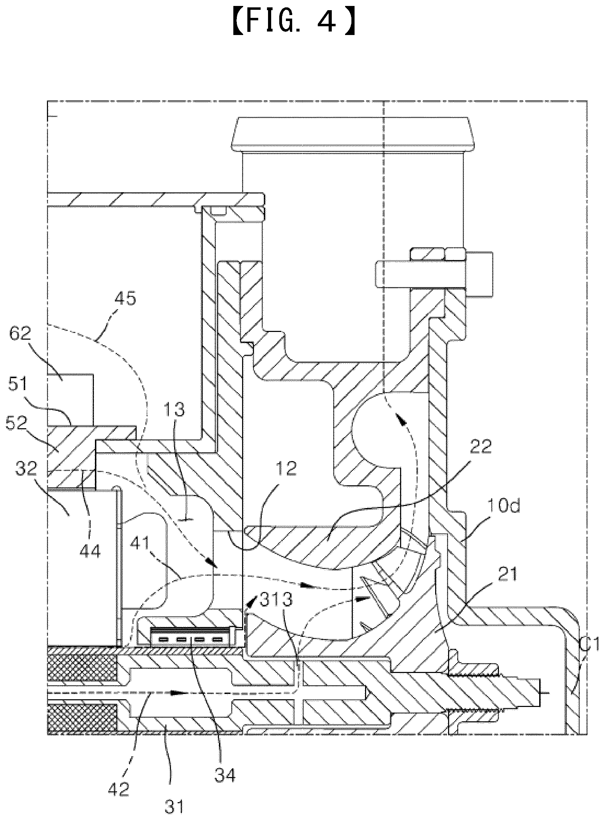

FIG. 4 is a partially enlarged view of the rear end of the turbo compressor illustrated in FIG. 2.

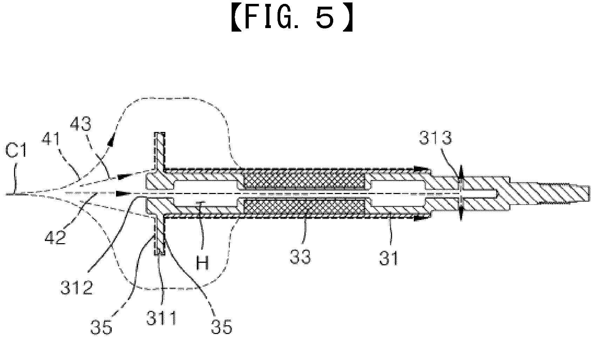

FIG. 5 is a cross-sectional view of a rotating shaft illustrated in FIG. 1 and its surrounding area.
FIG. 6 is a cross-sectional view taken along line VI-VI of FIG. 1.
FIG. 7 is a cross-sectional view of a general turbo compressor.

### BEST MODE

Hereinafter, the present invention will be described in detail by explaining embodiments of the invention with reference to the attached drawings.

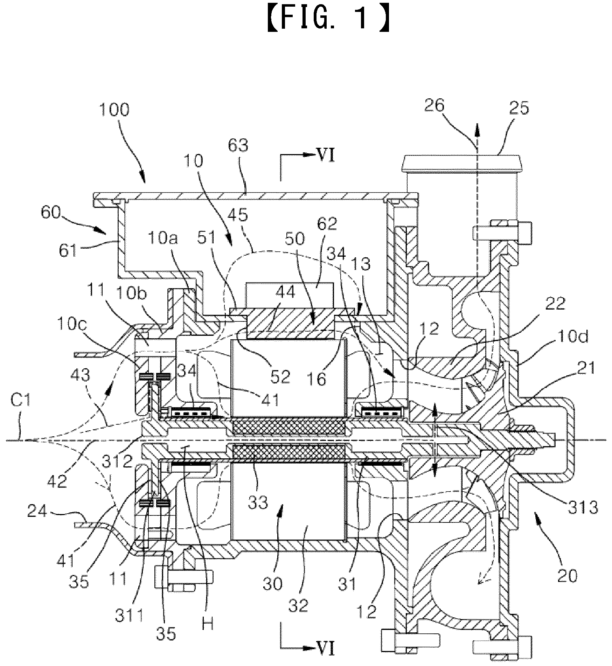

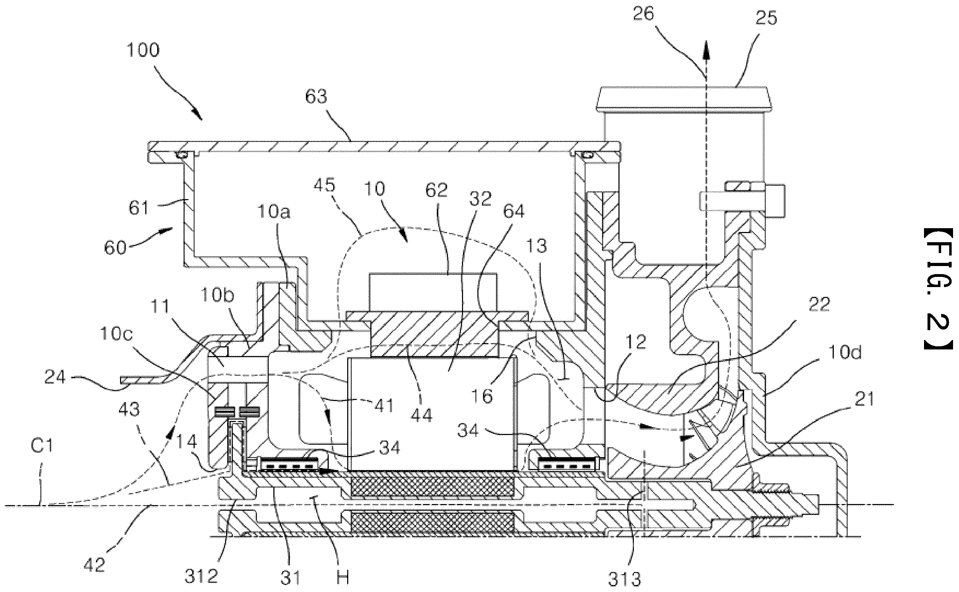

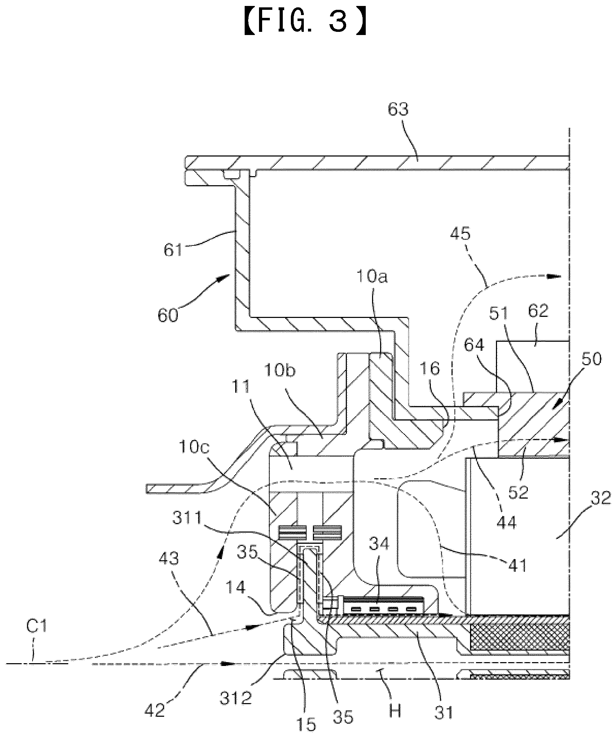

FIG. 1 is a cross-sectional view of a turbo compressor according to an embodiment of the present invention, and FIG. 2 is a partially enlarged view of the turbo compressor illustrated in FIG. 1. FIG. 3 is a partially enlarged view of the front end of the turbo compressor illustrated in FIG. 2.

Referring to FIGS. 1 to 3, a turbo compressor 100 according to an embodiment of the present invention is a centrifugal pump that sucks in and compresses external gas and then discharges the compressed gas to the outside by rotating an impeller at high speed, and is also called a turbo blower. The turbo compressor 100 includes a housing 10, a compression unit 20, a motor 30, a cooling gas path, a heat sink 50, and a power converter 60. The following description assumes that the gas to be compressed is air.

The housing 10 is a metal housing, is a cylindrical member including a motor accommodation space 13, has a cross-section with a first central axis C1 as the center of a circle, and extends along the first central axis C1.

The motor accommodation space 13 is a space with a shape corresponding to the motor 30 to be described below to accommodate the motor 30.

As shown in FIG. 2, an impeller 21 of the compression unit 20 is disposed at the rear end of the housing 10.

The housing 10 is divided into a plurality of components to mount the motor 30 therein, and includes a first housing 10a, a second housing 10b, a third housing 10c, and a fourth housing 10d in the current embodiment.

The first housing 10a is a cylindrical member having a cross-section with the first central axis C1 as the center of a circle.

At least one second through-hole 12 for allowing the gas accommodated in the motor accommodation space 13 to flow toward the impeller 21 is formed at the rear end of the first housing 10a.

In the current embodiment, a plurality of second through-holes 12 may be provided and arranged at predetermined intervals along the circumferential direction of a rotating shaft 31 to be described below.

The second through-hole 12 may be formed in various shapes, e.g., a circular hole, a slit-shaped hole extending along the radius direction of the rotating shaft 31, or a fan-shaped hole decreasing in width toward the rotating shaft 31.

In the current embodiment, the second through-hole 12 is connected to the inside of a gas guide member 22 to be described below.

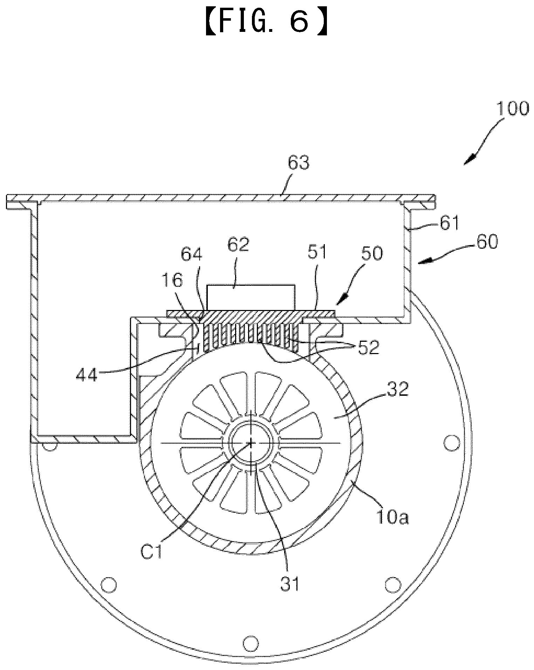

As shown in FIGS. 1 and 6, an opening 16 for allowing cooling fins 52 of the heat sink 50 to be described below to pass through is formed at the top of the first housing 10a.

The second housing 10b is a disc-shaped member detachably attached to the front end of the first housing 10a, and is provided in a shape capable of enabling the mounting of journal bearings 34, thrust bearings 35, and rotating shaft 31 to be described below, as shown in FIG. 3.

The second housing 10b is provided in a shape capable of closing the front end of the first housing 10a.

The third housing 10c is a disc-shaped member detachably attached to the front end of the second housing 10b, and is provided in a shape capable of enabling the mounting of the thrust bearings 35 and rotating shaft 31 to be described below, as shown in FIG. 3.

The third housing 10c is provided to restrict a thrust bearing runner 311 and thrust bearings 35 to be described below, from falling off forward.

A circular hole 14 with a diameter large enough to accommodate the rotating shaft 31 is formed at the center of the third housing 10c.

As shown in FIG. 2, at least one first through-hole 11 for allowing the gas sucked in from the compressed gas inlet 24 to flow into the motor accommodation space 13 is formed in the second and third housings 10b and 10c.

In the current embodiment, a plurality of first through-holes 11 may be provided and arranged at predetermined intervals along the circumferential direction of the rotating shaft 31.

The first through-hole 11 may be formed in various shapes, e.g., a circular hole, a slit-shaped hole extending along the radius direction of the rotating shaft 31, or a fan-shaped hole decreasing in width toward the rotating shaft 31.

In the third housing 10c, at least one third through-hole 15 for allowing the gas sucked in from the compressed gas inlet 24 to flow toward the thrust bearings 35 is formed.

In the current embodiment, as shown in FIG. 3, the third through-hole 15 includes a circular ring-shaped hole 15 formed by the cooperation of the circular hole 14 provided in the third housing 10c, and the front end of the rotating shaft 31 disposed in the circular hole 14 and to be described below.

The fourth housing 10d is a disc-shaped member as shown in FIG. 1, and is a member for closing the rear end of the gas guide member 22 to be described below.

The compression unit 20 is a device for sucking in and compressing external air, and includes the impeller 21 and the gas guide member 22.

The impeller 21 is a major component of the centrifugal pump, is a wheel including a plurality of curved blades, and is mounted to rotate at high speed.

The gas guide member 22 is a metal member disposed in front of the impeller 21, and is a member for guiding the air introduced into and to be compressed by the impeller 21, and the air compressed by the impeller 21.

The gas guide member 22 is provided to close the rear end of the first housing 10a.

In the current embodiment, as shown in FIG. 1, the gas guide member 22 is provided in the form of a scroll casing including paths for allowing the air having passed through the impeller 21 to flow in a spiral shape.

The impeller 21 compresses the air introduced through the compressed gas inlet 24 to be described below, and the air compressed by the impeller 21 is discharged to the outside through a compressed gas outlet 25.

The compressed gas inlet 24 is a member for sucking in external air to be compressed, is disposed at the front end of the housing 10, and is detachably coupled to the front end of the second housing 10b in the current embodiment.

The air sucked into the compressed gas inlet 24 is compressed while moving along a compressed gas path 26 connected from the compressed gas inlet 24 to the compressed gas outlet 25.

The motor 30 is an electric motor for generating rotational force, and is a device for supplying high-speed rotational force to the impeller 21. The motor 30 includes the rotating shaft 31, a stator 32, a rotor 33, the journal bearings 34, and the thrust bearings 35.

The rotating shaft 31 is a rod member extending along the first central axis C1, and the rear end thereof is relatively non-rotatably coupled to the impeller 21 to rotate the impeller 21.

The rotating shaft 31 includes a borehole H extending along the first central axis C1 which corresponds to the longitudinal direction of the rotating shaft 31.

The thrust bearing runner 311 with the position and shape corresponding to the thrust bearings 35 is provided at the front end of the rotating shaft 31.

In the current embodiment, the thrust bearing runner 311 is a general disc-shaped runner.

A gas inlet hole 312 connected to the borehole H of the rotating shaft 31 is formed at the front end of the rotating shaft 31.

The gas inlet hole 312 is a hole for guiding the air introduced through the compressed gas inlet 24, into the borehole H.

In the current embodiment, the gas inlet hole 312 is positioned inside the circular hole 14 of the third housing 10c.

At least one gas outlet hole 313 connected to the borehole H of the rotating shaft 31 is formed at the rear end of the rotating shaft 31.

The gas outlet hole 313 is a hole for guiding the air introduced into the borehole H of the rotating shaft 31, toward the impeller 21.

In the current embodiment, a plurality of gas outlet holes 313 may be provided and arranged at predetermined intervals along the circumferential direction of the rotating shaft 31.

In the current embodiment, as shown in FIG. 1, the gas outlet hole 313 is positioned between the stator 32 of the motor 30 and the impeller 21, and is disposed inside the gas guide member 22.

The stator 32 is a stator wound with a field coil and is fixedly mounted in the motor accommodation space 13.

The rotor 33 is a rotor including a permanent magnet and is coupled to a middle portion of the rotating shaft 31.

The journal bearings 34 are journal foil air bearings rotatably supporting the rotating shaft 31 to reduce frictional force caused by high-speed rotation, and are provided separately at the front and rear ends of the rotating shaft 31.

One of the journal bearings 34 at the front end of the rotating shaft 31 is disposed behind the thrust bearings 35.

The thrust bearings 35 are thrust foil air bearings, and a pair of thrust bearings 35 are disposed separately on both surfaces of the thrust bearing runner 311.

In the current embodiment, as shown in FIG. 1, the thrust bearings 35 are disposed at the foremost part of the housing 10.

Predetermined gaps are provided between the stator 32 and the rotor 33, between the rotating shaft 31 and the stator 32, between the rotating shaft 31 and the journal bearings 34, and between the thrust bearings 35 and the thrust bearing runner 311.

Consequently, in the current embodiment, the motor 30 is disposed between the compressed gas inlet 24 and the impeller 21.

The cooling gas path is a gas path formed to allow a cooling gas accommodated inside to flow, and includes a first cooling gas path 41, a second cooling gas path 42, a third cooling gas path 43, a fourth cooling gas path 44, and a fifth cooling gas path 45.

Herein, the cooling gas is a gas to be compressed, which is sucked in from the compressed gas inlet 24 by the suction force of the impeller 21, e.g., air.

As shown in FIG. 2, the first cooling gas path 41 is a cooling gas path starting from the compressed gas inlet 24, passing along the outer circumferential surface of the rotating shaft 31, and reaching the impeller 21.

In the current embodiment, as shown in FIG. 2, the first cooling gas path 41 starts from the compressed gas inlet 24, passes sequentially through the first through-hole 11, the front end of the motor accommodation space 13, the space between the stator 32 and the outer circumferential surface of the rotating shaft 31, and the second through-hole 12, and reaches the impeller 21.

Therefore, the first cooling gas path 41 may rapidly cool the stator 32 of the motor 30.

In the current embodiment, as shown in FIG. 3, the first cooling gas path 41 is provided to cool the thrust bearings 35 by passing through the space where the thrust bearing runner 311 is accommodated, while penetrating through the first through-hole 11.

As shown in FIG. 2, the second cooling gas path 42 is a cooling gas path starting from the compressed gas inlet 24, passing through the borehole H of the rotating shaft 31, and reaching the impeller 21.

In the current embodiment, as shown in FIG. 2, the second cooling gas path 42 starts from the compressed gas inlet 24, passes sequentially through the gas inlet hole 312, the borehole H of the rotating shaft 31, and the gas outlet hole 313, and reaches the impeller 21.

Therefore, the second cooling gas path 42 may rapidly cool the rotor 33 of the motor 30.

The third cooling gas path 43 is a cooling gas path starting from the compressed gas inlet 24, passing through the thrust bearings 35, and reaching the impeller 21.

In the current embodiment, as shown in FIG. 3, the third cooling gas path 43 starts from the compressed gas inlet 24, passes sequentially through the thrust bearings 35, the journal bearings 34, the front end of the motor accommodation space 13, the space between the stator 32 and the outer circumferential surface of the rotating shaft 31, and the second through-hole 12, and reaches the impeller 21.

Therefore, the third cooling gas path 43 may rapidly cool the thrust bearings 35 and the journal bearings 34.

In the current embodiment, as shown in FIG. 3, the third cooling gas path 43 merges with the first cooling gas path 41 at the rear end of the motor accommodation space 13.

The fourth cooling gas path 44 is a cooling gas path starting from the compressed gas inlet 24, passing through the other end of the heat sink 50, and reaching the impeller 21.

In the current embodiment, the fourth cooling gas path 44 starts from the compressed gas inlet 24, passes sequentially through the first through-hole 11, the cooling fins 52 of the heat sink 50, and the second through-hole 12, and reaches the impeller 21.

As shown in FIG. 6, the fourth cooling gas path 44 includes a plurality of cooling gas paths formed by the cooperation of the surface of the cooling fins 52, the outer surface of the stator 32, and the inner surface of the opening 16.

Therefore, the fourth cooling gas path 44 may rapidly cool the power converter 60 by cooling the cooling fins 52.

In the current embodiment, as shown in FIG. 3, the fourth cooling gas path 44 merges with the first and third cooling gas paths 41 and 43 at the rear end of the motor accommodation space 13.

The fifth cooling gas path 45 is a cooling gas path starting from the compressed gas inlet 24, passing through the internal space of a case 61 of the power converter 60 to be described below, and reaching the impeller 21.

In the current embodiment, as shown in FIG. 1, the fifth cooling gas path 45 starts from the compressed gas inlet 24, passes sequentially through the first through-hole 11, the internal space of the case 61, and the second through-hole 12, and reaches the impeller 21.

Therefore, the fifth cooling gas path 45 has a structure in which the air introduced through the compressed gas inlet 24 directly flows into the internal space of the case 61 and rapidly cools heat sources of the power converter 60.

In the current embodiment, as shown in FIG. 3, the fifth cooling gas path 45 merges with the first, third, and fourth cooling gas path 41, 43, and 44 at the rear end of the motor accommodation space 13.

As a result, the cooling gas paths 41, 42, 43, 44, and 45 are disposed in front of the compressed gas path 26, and the air to be compressed, which flows from the upstream side of the impeller 21 toward the impeller 21 along the compressed gas path 26, functions as a cooling gas.

The heat sink 50 is a thermally conductive heat sink for cooling the heat sources of the power converter 60, and includes a body 51 and the cooling fins 52.

As shown in FIG. 2, the body 51 is a rectangular plate-shaped metal member, and is provided at an end of the heat sink 50.

The body 51 is disposed in the internal space of the case 61 in contact with the heat sources of the power converter 60.

The cooling fins 52 are members for increasing the heat exchange efficiency with the cooling gas flowing through the fourth cooling gas path 44, and are provided at the other end of the heat sink 50.

A plurality of cooling fins 52 may be provided, and are inserted into the motor accommodation space 13 through the opening 16 of the first housing 10a as shown in FIG. 2.

In the current embodiment, the cooling fins 52 protrude toward the rotating shaft 31 and extend along the longitudinal direction C1 of the rotating shaft 31 as shown in FIG. 2, and are spaced apart from each other along the circumferential direction of the rotating shaft 31 as shown in FIG. 6.

At least some of the distal ends of the cooling fins 52 may be in contact with or disposed closely within a predetermined distance from the outer surface of the stator 32 of the motor 30.

In the current embodiment, all the distal ends of the cooling fins 52 are in contact with the outer surface of the stator 32 of the motor 30 as shown in FIG. 6.

The power converter 60 is a device for converting electricity to control the motor 30, e.g., a device for converting a direct current (DC) component into an alternating current (AC) component or vice versa and supplying the converted power to the motor 30. The power converter 60 includes the case 61, a switching module 62, a lid 63, and a through-hole 64.

The case 61 is a metal container capable of accommodating various heat sources in the internal space, and may have an airtight structure to prevent flames from escaping even when the heat sources therein burn.

In the current embodiment, the case 61 is disposed on top of the first housing 10a, and is in contact with the outer circumferential surface of the first housing 10a as shown in FIG. 1 to exchange heat with the housing 10.

In the current embodiment, the case 61 is coupled to the body 51 of the heat sink 50 in contact with each other to exchange heat with the body 51.

At least one air hole (not shown) for allowing the air flowing along the fifth cooling gas path 45 to enter and exit is formed in the bottom surface of the case 61. In the current embodiment, as shown in FIG. 2, at least one air hole (not shown) is provided at both the front and rear of the heat sink 50 to connect the opening 16 of the first housing 10a with the internal space of the case 61.

The switching module 62 is a major heat source of the power converter 60, and includes an insulated/isolated gate bipolar transistor (IGBT).

In addition to the switching module 62 which is a major heat source, the power converter 60 also includes various heat sources, e.g., a controller for controlling the overall operation of the motor 30 including the rotation speed of the motor 30.

In the current embodiment, the switching module 62 is disposed near the bottom surface of the case 61, and coupled to the top surface of the body 51 of the heat sink 50 in close contact.

The switching module 62 is a key component of an inverter which converts a DC component into an AC component.

The inverter is also called a power inverter, and obtains desired voltage and frequency output values through an appropriate conversion method, switching device, or control circuit.

The lid 63 is a metal plate member, and is a member for detachably closing the open top of the case 61 as shown in FIG. 2.

The through-hole 64 is a rectangular hole formed in the bottom surface of the case 61, and is provided in a shape capable of allowing the cooling fins 52 of the heat sink 50 to pass through.

In the current embodiment, the through-hole 64 has a size and shape capable of preventing the body 51 of the heat sink 50 from passing through.

An example of the operating method of the above-described turbo compressor 100 will now be described.

When the rotating shaft 31 of the motor 30 rotates, the impeller 21 rotates, and the air sucked in from the compressed gas inlet 24 by the suction force of the impeller 21 flows through the first, second, third, fourth, and fifth cooling gas paths 41, 42, 43, 44, and 45 to cool the motor 30.

The air having cooled the motor 30 is introduced into the gas guide member 22, compressed by the impeller 21, and then discharged to the outside through the compressed gas outlet 25.

In this case, the air moving along the first, second, third, fourth, and fifth cooling gas paths 41, 42, 43, 44, and 45 flows unidirectionally from the compressed gas inlet 24 to the impeller 21 without recirculating back to the compressed gas inlet 24.

As shown in FIG. 2, the air flowing along the first cooling gas path 41 may start from the compressed gas inlet 24, pass sequentially through the first through-hole 11, the front end of the motor accommodation space 13, the space between the stator 32 and the outer circumferential surface of the rotating shaft 31, and the second through-hole 12, and reach the impeller 21, thereby rapidly cooling the stator 32 and the outer circumferential surface of the rotating shaft 31.

As shown in FIG. 2, the air flowing along the second cooling gas path 42 may start from the compressed gas inlet 24, pass sequentially through the gas inlet hole 312, the borehole H of the rotating shaft 31, and the gas outlet hole 313, and reach the impeller 21, thereby rapidly cooling the rotor 33 and the borehole H of the rotating shaft 31.

As shown in FIG. 3, the air flowing along the third cooling gas path 43 may start from the compressed gas inlet 24, pass sequentially through the thrust bearings 35, the journal bearings 34, the front end of the motor accommodation space 13, the space between the stator 32 and the outer circumferential surface of the rotating shaft 31, and the second through-hole 12, and reach the impeller 21, thereby rapidly cooling the thrust bearings 35 and the journal bearings 34.

As shown in FIG. 2, the air flowing along the fourth cooling gas path 44 may start from the compressed gas inlet 24, pass sequentially through the first through-hole 11, the cooling fins 52 of the heat sink 50, and the second through-hole 12, and reach the impeller 21, thereby rapidly cooling the cooling fins 52 of the heat sink 50.

As shown in FIG. 2, the air flowing along the fifth cooling gas path 45 may start from the compressed gas inlet 24, pass sequentially through the first through-hole 11, the internal space of the case 61, and the second through-hole 12, and reach the impeller 21, thereby directly and rapidly cooling the heat sources of the power converter 60.

The above-described turbo compressor 100 is a turbo compressor capable of compressing a gas and supplying the compressed gas to the outside, and includes the compressed gas inlet 24 for sucking in the gas; the impeller 21 for compressing the gas introduced through the compressed gas inlet 24; the compressed gas outlet 25 for discharging the gas compressed by the impeller 21, to the outside; the compression unit 20 including the compressed gas inlet 24, the impeller 21, the compressed gas outlet 25, and the compressed gas path 26 connected from the compressed gas inlet 24 to the compressed gas outlet 25; the motor 30 including the rotating shaft 31 with an end coupled to the impeller 21, to rotate the impeller 21; the housing 10 including the motor accommodation space 13 for accommodating the motor 30; the cooling gas path provided to allow the cooling gas accommodated inside to flow; the power converter 60 provided as a device for controlling the motor 30, and including heat sources inside; and the heat sink 50 provided as a thermally conductive member for cooling the heat sources of the power converter 60, and having an end in contact with the heat sources and the other end exposed to the motor accommodation space 13, wherein the compressed gas inlet 24 is disposed at the front end of the housing 10, wherein the impeller 21 is disposed at the rear end of the housing 10, wherein the motor 30 is disposed between the compressed gas inlet 24 and the impeller 21, wherein the cooling gas path includes the fourth cooling gas path 44 starting from the compressed gas inlet 24, passing through the other end of the heat sink 50, and reaching the impeller 21, and wherein the gas sucked in from the compressed gas inlet 24 by the suction force of the impeller 21 passes through the fourth cooling gas path 44 to cool the heat sources of the power converter 60. Thus, the heat sources of the power converter 60 may be rapidly cooled using a relatively low-temperature cooling gas sucked in from the compressed gas inlet 24.

According to the turbo compressor 100, the power converter 60 includes the case 61 capable of accommodating the heat sources in the internal space, the cooling gas path includes the fifth cooling gas path 45 starting from the compressed gas inlet 24, passing through the internal space of the case 61, and reaching the impeller 21, and the gas sucked in from the compressed gas inlet 24 by the suction force of the impeller 21 passes through the fifth cooling gas path 45 to cool the heat sources of the power converter 60. Thus, the air introduced through the compressed gas inlet 24 may directly flow into the internal space of the case 61 to cool the heat sources of the power converter 60.

According to the turbo compressor 100, at least one first through-hole 11 for allowing the gas sucked in from the compressed gas inlet 24 to flow into the motor accommodation space 13 is formed at the front end of the housing 10, and at least one second through-hole 12 for allowing the gas accommodated in the motor accommodation space 13 to flow toward the impeller 21 is formed at the rear end of the housing 10. Thus, a structure for allowing the cooling gas to flow into and then out of the motor accommodation space 13 may be easily provided.

According to the turbo compressor 100, at least one of the first and second through-holes 11 and 12 includes a plurality of through-holes arranged at predetermined intervals along the circumferential direction of the rotating shaft 31. Thus, the flow rate and streamline shape of the air flowing into the motor accommodation space 13 may be easily controlled.

According to the turbo compressor 100, the fourth cooling gas path 44 starts from the compressed gas inlet 24, passes sequentially through the first through-hole 11, the other end of the heat sink 50, and the second through-hole 12, and reaches the impeller 21. Thus, the motor 30 and the power converter 60 may be cooled simultaneously.

According to the turbo compressor 100, the fifth cooling gas path 45 starts from the compressed gas inlet 24, passes sequentially through the first through-hole 11, the internal space of the case 61, and the second through-hole 12, and reaches the impeller 21. Thus, indirect cooling through the heat sink 50 and direct cooling through entry into the case 61 may be implemented simultaneously.

According to the turbo compressor 100, a plurality of cooling fins 52 are provided at the other end of the heat sink 50. Thus, the heat exchange efficiency between the cooling gas and the heat sink 50 may be significantly increased.

According to the turbo compressor 100, as shown in FIG. 6, the cooling fins 52 protrude toward the rotating shaft 31, extend along the longitudinal direction C1 of the rotating shaft 31, and are spaced apart from each other along the circumferential direction of the rotating shaft 31. Thus, the heat exchange efficiency may be increased without interfering with the airflow along the fourth cooling gas path 44.

According to the turbo compressor 100, as shown in FIG. 6, at least some of the distal ends of the cooling fins 52 are in contact with or disposed closely within a predetermined distance from the outer surface of the stator 32 of the motor 30. Thus, the protrusion length of the cooling fins 52 may be maximized, and a portion of heat produced by the stator 32 may be conducted to the heat sink 50.

According to the turbo compressor 100, the power converter 60 includes the case 61 capable of accommodating internal heat sources, and the case 61 includes a metal and is coupled to an end of the heat sink 50 to exchange heat with the heat sink 50. Thus, through heat transfer from the heat sink 50 to the case 61, the case 61 may function as a second thermally conductive heat sink.

According to the turbo compressor 100, the cooling gas paths 41, 42, 43, 44, and 45 are formed to allow the cooling gas to flow unidirectionally from the compressed gas inlet 24 to the impeller 21 without recirculating. Thus, the "vortex flow" which causes the heated cooling air to return to the upstream side of the impeller and be compressed again may not occur, thereby achieving excellent compression efficiency of the impeller 21.

According to the turbo compressor 100, the first cooling gas path 41 is formed to cool the stator 32 of the motor 30. Thus, the stator 32 may be rapidly cooled using a relatively low-temperature cooling gas. Herein, the amount of air flowing along the first cooling gas path 41 may be easily controlled by adjusting the sizes or numbers of first through-holes 11 and second through-holes 12.

According to the turbo compressor 100, the second cooling gas path 42 is formed to cool the rotor 33 of the motor 30. Thus, the rotor 33 may be rapidly cooled using a relatively low-temperature cooling gas. Herein, the amount of air flowing along the second cooling gas path 42 may be easily controlled by adjusting the sizes or numbers of gas inlet holes 312, boreholes H, and gas outlet holes 313.

According to the turbo compressor 100, the motor 30 further includes the thrust bearings 35 disposed at the front end of the rotating shaft 31, and the cooling gas path further includes the third cooling gas path 43 starting from the compressed gas inlet 24, passing through the thrust bearings 35, and reaching the impeller 21. Thus, the thrust bearings 35 may be rapidly cooled using a relatively low-temperature cooling gas.

According to the turbo compressor 100, at least one third through-hole 15 for allowing the gas sucked in from the compressed gas inlet 24 to flow toward the thrust bearings 35 is formed at the front end of the housing 10. Thus, the flow rate and streamline shape of the air flowing along the third cooling gas path 43 may be easily controlled.

According to the turbo compressor 100, the third through-hole 15 includes the circular ring-shaped hole 15 formed by the cooperation of the circular hole 14 provided at the front end of the housing 10, and the front end of the rotating shaft 31 disposed in the circular hole 14. Thus, the third through-hole 15 may be easily formed without a complex cutting process.

According to the turbo compressor 100, the rotating shaft 31 includes the gas inlet hole 312 connected to the borehole H of the rotating shaft 31 and formed at the front end of the rotating shaft 31; and the gas outlet hole 313 connected to the borehole H of the rotating shaft 31 and formed at the rear end of the rotating shaft 31, and the gas outlet hole 313 is disposed between the stator 32 of the motor 30 and the impeller 21. Thus, the air flowing along the second cooling gas path 42 may directly reach the impeller 21 without being mixed with the air flowing along the other cooling gas paths 41 and 43. As such, the flow rate of the air flowing along the second cooling gas path 42 may be controlled separately and very easily.

Although the cooling gas paths 41, 42, 43, and 45 do not include cooling fins in the current embodiment, the cooling gas paths may include cooling fins. **In** this case, the cooling fins may be integrated with the housing 10, or be produced as separate members and then coupled to the housing 10 through press fitting or the like.

Although the bearings 34 and 35 are provided as foil air bearings in the current embodiment, other types of air bearings or various types of other bearings may also be used.

Although a sealing means for airtightness is not described in the current embodiment, various types of sealing means may be used.

While the present invention has been particularly shown and described with reference to embodiments thereof, it will be understood by one of ordinary skill in the art that various changes in form and details may be made therein without departing from the scope of the present invention as defined by the following claims.

## Claims

1. A turbo compressor capable of compressing a gas and supplying the compressed gas to outside, the turbo compressor comprising:
a compressed gas inlet for sucking in the gas;
an impeller for compressing the gas introduced through the compressed gas inlet;
a compressed gas outlet for discharging the gas compressed by the impeller, to outside;
a compression unit comprising the compressed gas inlet, the impeller, the compressed gas outlet, and a compressed gas path connected from the compressed gas inlet to the compressed gas outlet;
a motor comprising a rotating shaft with an end coupled to the impeller, to rotate the impeller;
a housing comprising a motor accommodation space for accommodating the motor;
a cooling gas path provided to allow a cooling gas accommodated inside to flow;
a power converter provided as a device for controlling the motor, and comprising heat sources inside; and
a heat sink provided as a thermally conductive member for cooling the heat sources of the power converter, and having an end in contact with the heat sources and the other end exposed to the motor accommodation space,
wherein the compressed gas inlet is disposed at a front end of the housing,
wherein the impeller is disposed at a rear end of the housing,
wherein the motor is disposed between the compressed gas inlet and the impeller,
wherein the cooling gas path comprises a fourth cooling gas path starting from the compressed gas inlet, passing through the other end of the heat sink, and reaching the impeller, and
wherein the gas sucked in from the compressed gas inlet by suction force of the impeller passes through the fourth cooling gas path to cool the heat sources of the power converter.

2. The turbo compressor of claim 1, wherein the power converter comprises a case capable of accommodating the heat sources in an internal space,
wherein the cooling gas path comprises a fifth cooling gas path starting from the compressed gas inlet, passing through the internal space of the case, and reaching the impeller, and
wherein the gas sucked in from the compressed gas inlet by suction force of the impeller passes through the fifth cooling gas path to cool the heat sources of the power converter.

3. The turbo compressor of claim 1 or 2, wherein at least one first through-hole for allowing the gas sucked in from the compressed gas inlet to flow into the motor accommodation space is formed at the front end of the housing, and
wherein at least one second through-hole for allowing the gas accommodated in the motor accommodation space to flow toward the impeller is formed at the rear end of the housing.

4. The turbo compressor of claim 3, wherein at least one of the first and second through-holes comprises a plurality of through-holes arranged at predetermined intervals along a circumferential direction of the rotating shaft.

5. The turbo compressor of claim 3, wherein the fourth cooling gas path starts from the compressed gas inlet, passes sequentially through the first through-hole, the other end of the heat sink, and the second through-hole, and reaches the impeller.

6. The turbo compressor of claim 3, wherein the fifth cooling gas path starts from the compressed gas inlet, passes sequentially through the first through-hole, the internal space of the case, and the second through-hole, and reaches the impeller.

7. The turbo compressor of claim 1, wherein a plurality of cooling fins are provided at the other end of the heat sink.

8. The turbo compressor of claim 7, wherein the cooling fins protrude toward the rotating shaft, extend along a longitudinal direction of the rotating shaft, and are spaced apart from each other along a circumferential direction of the rotating shaft.

9. The turbo compressor of claim 7, wherein at least some of distal ends of the cooling fins are in contact with or disposed closely within a predetermined distance from an outer surface of a stator of the motor.

10. The turbo compressor of claim 1, wherein the power converter comprises a case capable of accommodating internal heat sources, and
wherein the case comprises a metal and is coupled to an end of the heat sink to exchange heat with the heat sink.
